Europäisches Patentamt

European Patent Office

Office européen des brevets

(11) Numéro de publication : **0 309 350 B1**

(12)

# FASCICULE DE BREVET EUROPEEN

(45) Date de publication du fascicule du brevet :
**10.06.92 Bulletin 92/24**

(51) Int. Cl.$^5$ : **G01R 29/06**

(21) Numéro de dépôt : **88402385.4**

(22) Date de dépôt : **22.09.88**

(54) **Dispositif de mesure de produits d'intermodulation d'un système récepteur.**

(30) Priorité : **25.09.87 FR 8713317**

(43) Date de publication de la demande :
**29.03.89 Bulletin 89/13**

(45) Mention de la délivrance du brevet :
**10.06.92 Bulletin 92/24**

(84) Etats contractants désignés :
**AT BE CH DE ES FR GB GR IT LI LU NL SE**

(56) Documents cités :
**GB-A- 681 673**
**US-A- 3 467 866**
**TLE, no. 495, juin-juillet 1984, pages 70-73; T. TURNER et al.: "L'identification des produits d'intermodulation"**

(56) Documents cités :
**IEEE TRANSACTIONS ON MICROWAVE THEORY AND TECHNIQUES, vol. MTT-31, no. 7, juillet 1983, pages 605-606, IEEE; J.R. ASHLEY etal.: "Comments on discriminator theory"**

(73) Titulaire : **CENTRE NATIONAL D'ETUDES SPATIALES**
**2, Place Maurice Quentin**
**F-75001 Paris (FR)**

(72) Inventeur : **Boschet, Christian**
**124 Les Jardins de Nanbours Auzielle**
**F-31650 Saint Orens de Gameville (FR)**
Inventeur : **Sombrin, Jacques**
**104 Chemin de Lespinet**
**F-31400 Toulouse (FR)**

(74) Mandataire : **Schrimpf, Robert et al**
**Cabinet Regimbeau 26, Avenue Kléber**
**F-75116 Paris (FR)**

## Description

La présente invention est relative à un dispositif de mesure de produits d'intermodulation d'un système récepteur selon le préambule de la revendication 1.

Un tel dispositif est connu par exemple du TLE, no. 495, juin-juillet 1984, pages 70-93.

Dans le domaine technique de haute technicité relatif aux télécommunications par satellite ou à la détection électromagnétique radar, il est nécessaire de pouvoir mesurer les produits d'intermodulation d'au moins deux signaux électromagnétiques d'émission, de fréquence différente, ces signaux étant reçus par un système récepteur dont on veut mesurer les performances d'intermodulation aux fréquences précitées.

Les valeurs maximales tolérables de niveau d'amplitude ou d'énergie des produits d'intermodulation étant en général très faibles, ces valeurs, pour les harmoniques de produit d'intermodulation dont la fréquence est comprise dans la bande de fréquence de réception du système récepteur, ne doivent pas bien entendu être supérieures à la sensibilité du système récepteur ou, selon un aspect complémentaire, la sensibilité du récepteur dans sa bande de fréquence de réception ne peut être meilleure que les niveaux d'énergie de produits d'intermodulation dans la bande de fréquence précitée.

Bien entendu, le dispositif de mesure lui-même doit impérativement engendrer des niveaux d'énergie d'intermodulation très faibles par rapport aux valeurs maximales tolérables, pour un système récepteur donné.

Le dispositif de mesure de produits d'intermodulation d'un système récepteur d'au moins deux signaux électromagnétiques d'émission de fréquence différente, objet de la présente invention, a pour objet la mise en oeuvre d'un dispositif satisfaisant aux spécifications précitées.

Un autre objet du dispositif de mesure, objet de l'invention, est la mise en oeuvre d'un dispositif de mesure de produits d'intermodulation passifs ou actifs.

Un autre objet du dispositif de mesure objet de l'invention est la mise en oeuvre d'un dispositif présentant un caractère modulaire, ce caractère modulaire permettant d'envisager une mise en oeuvre du dispositif de mesure selon l'invention dans le cas de la mesure de produits d'intermodulation de plus de deux signaux électromagnétiques d'émission par seule extension modulaire.

Un autre objet de la présente invention est enfin la mise en oeuvre d'un système de mesure des produits d'intermodulation engendrés par un système récepteur soit par réflexion, le système récepteur pouvant d'ailleurs consister simplement en un matériau réflecteur, soit en transmission, le système récepteur pouvant consister en tout ou partie d'une antenne hyperfréquences.

Le dispositif de mesure de produits d'intermodulation d'un système récepteur d'au moins deux signaux électromagnétiques d'émission de fréquence différente, objet de l'invention, est remarquable en ce que ce dispositif comporte au moins deux voies d'émission des signaux électromagnétiques d'émission. Chaque voie permet la transmission d'un des signaux de fréquence donnée. Le dispositif comporte en outre une voie de réception en réflexion connectée à un appareil de mesure des produits d'intermodulation. La voie de réception permet la transmission des signaux électromagnétiques dans une bande de fréquence centrée sur la bande de fréquence de réception du système récepteur. Les deux voies d'émission, la voie de réception et le système récepteur sont interconnectées par l'intermédiaire d'un multiplexeur-démultiplexeur de réception en réflexion à filtres directifs. Les entrées/sorties du multiplexeur/démultiplexeur de réception en réflexion sont respectivement connectées à la première et à la deuxième voie d'émission, à la voie de réception en réflexion et au système récepteur, le multiplexeur/démultiplexeur comportant un filtre directif associé à chaque voie. Chaque filtre directif est passant à la fréquence des signaux électromagnétiques transmis par la voie à laquelle celui-ci est associé et réflecteur à la fréquence des signaux électromagnétiques des autres voies et des produits d'intermodulation située en dehors de la bande de fréquence de réception.

Le dispositif de mesure de produits d'intermodulation d'un système récepteur objet de la présente invention peut avantageusement être utilisé dans le domaine de l'instrumentation de la détection électromagnétique radar, des télécommunications par satellite et de façon plus générale dans le domaine de la transmission d'informations par ondes électromagnétiques lorsque deux ou plusieurs fréquences d'émission sont utilisées et que la réception est effectuée avec la même antenne sur une bande de fréquence de réception décalée par rapport à la bande de fréquence d'émission.

L'invention sera mieux comprise à la lecture de la description et à l'observation des dessins ci-après dans lesquels :

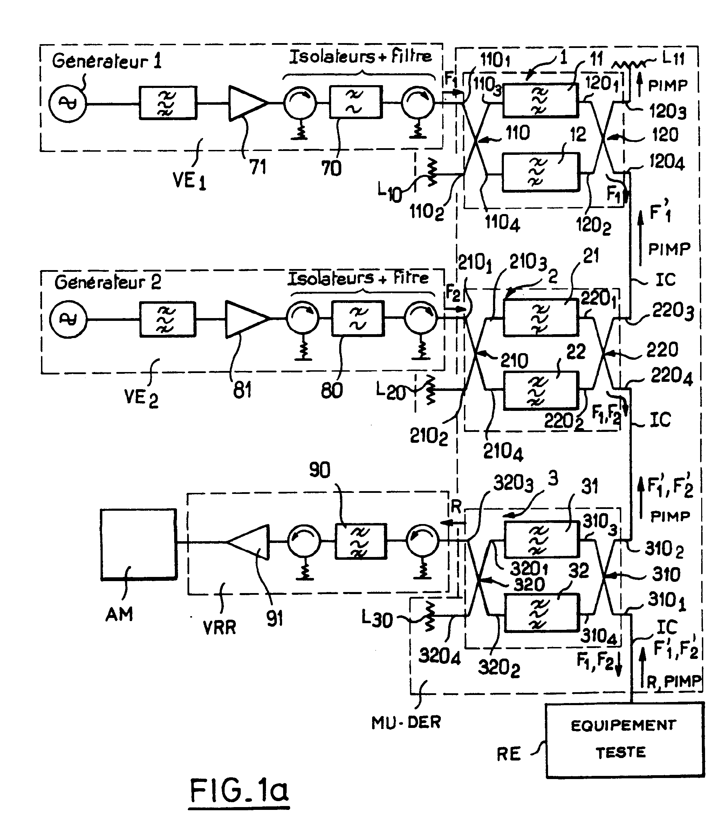

– la figure 1a représente un schéma du dispositif de mesure de produits d'intermodulation d'un système récepteur d'au moins deux signaux électromagnétiques d'émission de fréquence différente, objet de l'invention, selon un premier mode de réalisation non limitatif plus particulièrement destiné à la mesure de produits d'intermodulation engendrés par le système récepteur par réflexion,

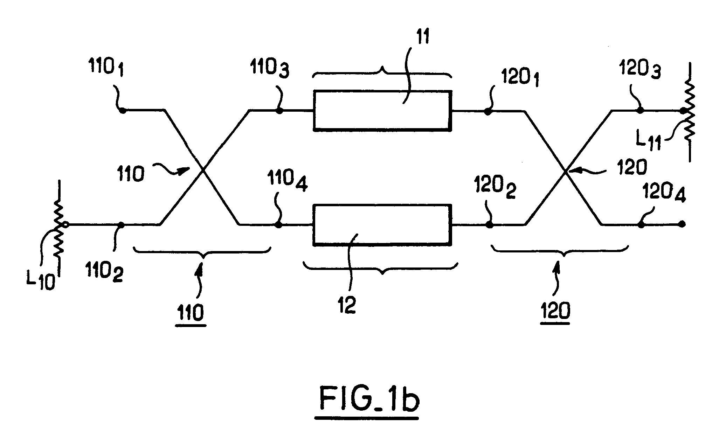

– la figure 1b représente un schéma représentatif d'un élément constitutif du dispositif objet de l'invention représenté en figure 1a,

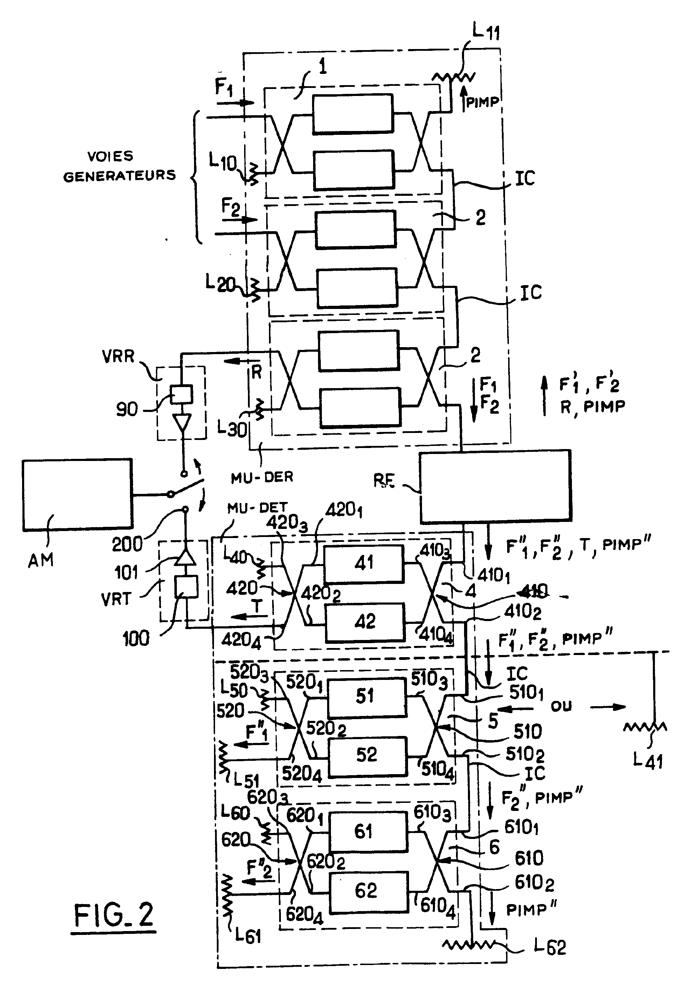

– la figure 2 représente un schéma du dispositif de mesure de produits d'intermodulation d'un système récepteur d'au moins deux signaux électromagnétiques d'émission de fréquence différente objet de l'invention, selon un deuxième mode de réalisation non limitatif plus particulièrement destiné à la mesure de produits d'intermodulation engendrés par le système récepteur par réflexion et/ou par transmission.

Le dispositif de mesure de produits d'intermodulation d'un système récepteur d'au moins deux signaux électromagnétiques d'émission de fréquence différente, objet de l'invention, sera tout d'abord décrit en liaison avec la figure 1a.

Sur la figure 1a précitée, les signaux électromagnétiques d'émission de fréquence différente sont réputés être émis à des fréquences F1 et F2.

Ainsi qu'on le remarquera sur la figure 1a précitée, le dispositif objet de l'invention comporte au moins deux voies d'émission VE1 et VE2 des signaux électromagnétiques d'émission précités. Chaque voie permet la transmission d'un desdits signaux de fréquence F1 ou F2.

En outre, ainsi qu'on le remarquera également sur la figure précitée, le dispositif objet de l'invention comprend une voie de réception en réflexion VRR connectée à un appareil de mesure AM des produits d'intermodulation. La voie de réception VRR permet la transmission de signaux électromagnétiques dans une bande de fréquence centrée sur la bande de fréquence de réception du système récepteur à tester, celui-ci étant noté RE.

En outre, un multiplexeur/démultiplexeur de réception en réflexion noté MU-DER, à filtres directifs, permet d'interconnecter d'une part les deux voies d'émission VE1, VE1, la voie de réception en réflexion VRR et le système récepteur RE. Les entrées/sorties du multiplexeur-démultiplexeur MU-DER sont respectivement connectées à la première et à la deuxième voies d'émission VE1, VE2, à la voie de réception en réflexion VRR et au système récepteur RE. Le multiplexeur/démultiplexeur comporte avantageusement un filtre directif 1,2, 3, associé à chaque voie. Chacun des filtres directifs 1, 2, 3 est passant à la fréquence des signaux électromagnétiques transmis par la voie à laquelle celui-ci est associé et réflecteur à la fréquence des signaux électromagnétiques des autres voies et des produits d'intermodulation situés en dehors de la bande de fréquence de réception du système récepteur RE.

Une description plus détaillée d'un mode de réalisation avantageux des filtres directifs, tels que des filtres directifs 1, 2, 3, constituant notamment le multiplexeur/démultiplexeur de réception en réflexion MU-DER, sera donnée en liaison avec la figure 1b.

Les références données en relation avec la figure 1b concernent toutes le mode de réalisation du premier filtre directif 1 et 1a description du filtre directif précité, vaut pour l'ensemble de tous les filtres directifs 2, 3 et suivants, pouvant être mis en oeuvre pour la réalisation du dispositif de l'invention, le premier chiffre de chaque référence dans le sens de lecture habituelle correspondant au numéro d'ordre du filtre directif correspondant, et la description des filtres directifs d'ordre supérieur à 1 étant déduite par seul remplacement dans ce premier filtre, de chacune des références par le numéro d'ordre correspondant du filtre directif d'ordre supérieur. Ainsi, à titre d'exemple non limitatif, le filtre directif 1 tel que représenté en figure 1b, peut être constitué avantageusement par un premier coupleur hybride noté 110, dont le premier port d'entrée noté $110_1$ reçoit le signal électromagnétique de fréquence correspondant à la fréquence de la voie considérée, le signal électromagnétique de fréquence F1. Le coupleur hybride constituant le premier coupleur hybride 110 peut avantageusement être constitué par un coupleur hybride normalement disponible dans le commerce. A ce titre, celui-ci ne sera pas décrit plus en détail dans la description.

Le filtre directif 1, ainsi que représenté en figure 1b, comprend également deux filres identiques notés 11 et 12, permettant la transmission de signaux électromagnétiques dans une bande de fréquence centrée sur la fréquence de la voie considérée, dans le cas du filtre directif 1, la fréquence F1. Chaque filtre 11, 12 est connecté respectivement au port de sortie $110_3$ et $110_4$ du premier coupleur hybride 110.

Le filtre directif 1, ainsi que représenté en figure 1b, comporte également un deuxième coupleur hybride 120, dont chaque port d'entrée $120_1$ et $120_2$ est connecté à la sortie d'un des deux filtres identiques 11, 12. Le deuxième port de sortie du deuxième coupleur hybride 120, port de sortie noté $120_4$, délivre le signal électromagnétique de fréquence correspondant à la fréquence de la voie considérée, la fréquence F1. Le premier port de sortie $120_3$ est connectée soit à une charge dissipative notée L11 dans le cas du premier filtre directif 1, soit au deuxième port de sortie du deuxième coupleur hybride d'un autre filtre directif, ainsi qu'il apparaît notamment en ce qui concerne le filtre directif 2.

Le deuxième port d'entrée noté $110_2$ du premier coupleur hybride 110 du premier filtre directif 1, est connecté à une charge dissipative L10 ou L20 dans le cas du deuxième port d'entrée du premier coupleur hybride 210 du deuxième filtre directif 2, ou au deuxième port de sortie $220_4$ du deuxième coupleur hybride d'un autre filtre directif, en l'occurence le filtre directif 2, dans le cas du troisième filtre directif, comportant le premier coupleur hybride 310. On comprendra bien entendu que les coupleurs hybrides présentent un fonctionnement absolument symétrique, les références relatives au premier et deuxième ports d'entrée et premier et deuxième ports de sortie peuvent être définis de façon arbitraire.

De préférence, chaque filtre identique, tel que les filtres 11 et 12, présente une bande passante, dont la fréquence centrale est centrée par exemple sur la demi-bande de fréquence d'émission supérieure et sur la demi-bande de fréquence inférieure, respectivement. Le taux de réjection de chaque filtre identique peut, par exemple, être pris égal à 15dB. De la même manière, en ce qui concerne les filtres 31 et 32 du troisième filtre directif 3, ceux-ci peuvent présenter une fréquence centrale centrée sur la demi-bande de réception supérieure et sur la demi-bande de réception inférieure.

Une description plus détaillée du mode de réalisation de la figure 1a, en liaison avec la figure 1b, du dispositif objet de l'invention, sera maintenant donnée pour le mode de réalisation considéré, lequel est susceptible d'assurer une mesure de produits d'intermodulation en réflexion du système réflecteur RE, pour deux signaux électromagnétiques d'émission de fréquence différente F1 et F2 précitées.

Dans le mode de réalisation précité, le premier $110_1$ et le deuxième $110_2$ port d'entrée du premier coupleur hybride 110 du premier filtre directif 1 sont respectivement connectés à la première voie d'émission VE1 et à une charge dissipative L10. Le premier port de sortie $120_3$ du deuxième coupleur hybride 120 du premier filtre directif 1 est lui-même connecté à une charge dissipative L11.

Le premier $210_1$ et le deuxième $210_2$ ports d'entrée du premier coupleur hybride 210 du deuxième filtre directif 2, sont respectivement connectés à la deuxième voie d'émission VE2 et à une charge dissipative L20. Le premier port de sortie $220_3$ du deuxième coupleur hybride 220 du deuxième filtre directif 2 est lui-même connecté au deuxième port de sortie $120_4$ du deuxième coupleur hybride 120 du premier filtre directif 1.

En outre, le premier $310_1$ et le deuxième $310_2$ port d'entrée du premier coupleur hybride 310 du troisième filtre directif 3, sont respectivement connectés au système récepteur RE à tester et au deuxième port de sortie $220_4$ du deuxième coupleur hybride 220 du deuxième filtre directif 2. Le premier $320_3$ et le deuxième $320_4$ port de sortie du deuxième coupleur hybride 320 du troisième filtre directif 3 est respectivement connecté à la voie de réception en réflexion VRR et à une charge dissipative L30.

Le principe de fonctionnement du dispositif de mesure objet de l'invention tel que représenté en figures 1a et 1b est le suivant:

le filtre directif 1, associé à la voie d'émission VE1 est composé de filtres passe-bande centrés sur la fréquence F1 et de bandes passantes aussi étroites que possible, compatibles avec la bande de fréquence à explorer.

Le signal électromagnétique d'émission provenant de la voie d'émission VE1, traverse le filtre directif 1 et est transmis dans la direction de l'équipement testé, le système récepteur RE.

Le filtre directif 2 est composé de la même manière de filtres centrés sur la fréquence F2 ainsi que précédemment mentionné. Les bandes passantes des filtres identiques 11, 12 et respectivement 21, 22 constituant les filtres directifs 1 et 2 sont disjointes, de telle sorte que :

– le signal électromagnétique d'émission de fréquence F1 est réfléchi sur les filtres 21, 22 du filtre directif 2 et est transmis dans la direction de l'équipement testé, le système récepteur RE.

– le signal électromagnétique d'émission de fréquence F2 traverse le filtre directif 2 et est transmis également dans la direction de l'équipement testé, le système récepteur RE.

De la même manière, le filtre directif 3 associé à la voie de réception en réflexion VRR est composé de filtres centrés sur la bande passante de réception du récepteur RT testé sur la fréquence centrale FR dont la bande passante est disjointe de celle des filtres directifs 1 et 2.

Les signaux électromagnétiques d'émission de fréquence F1 et F2 sont ainsi réfléchis sur le filtre directif 2 et sur le filtre directif 3, et sont ainsi transmis dans la direction de l'équipement testé, le système récepteur RE. Celui-ci reçoit donc les signaux électromagnétiques d'émission de fréquence F1 et F2 et les réfléchit en partie. Il engendre aussi, à partir des signaux électromagnétiques d'émission F1 et F2, des produits d'intermodulation, c'est-à-dire des signaux électromagnétiques de fréquence plus ou moins mF1, plus ou moins nF2, les valeurs positives de ces fréquences étant seules considérées, où m et n sont deux entiers quelconques représentatifs de l'ordre des produits d'intermodulation précités.

Parmi ces produits, il faut distinguer ceux dont la fréquence tombe dans la bande de réception R du récepteur RE constituant l'équipement testé et les produits d'intermodulation dont la fréquence est en dehors de la bande de réception précitée.

Les produits d'intermodulation dont la fréquence tombe dans la bande de fréquence de réception, sont alors transmis par le troisième filtre directif 3 et bien entendu par la voie de réception en réflexion VRR vers l'appareil de mesure AM.

Au contraire, les signaux électromagnétiques réfléchis, c'est-à-dire les produits d'intermodulation dont la fréquence se trouve en dehors de la bande de fréquence de réception R et les signaux électromagnétiques de fréquence F'1 et F'2 engendrés par réflexion pure par le système récepteur RE sont tout d'abord réfléchis par le troisième filtre directif 3, et sont donc transmis en sens inverse vers le deuxième filtre directif 2. Le signal électromagnétique de fréquence F2 se propageant dans la direction inverse précitée, est alors transmis par le filtre directif 2 précité et totalement absorbé par la chargé dissipative L20 de celui-ci, alors que les produits d'intermodulation dont la fréquence se trouve à l'extérieur de la bande de réception R et le signal électromagnétique de fréquence F1 qui se propage dans le sens inverse précité, sont transmis vers le premier filtre directif 1. Celui-ci, transmet le signal électromagnétique de fréquence F1 se propageant dans la direction opposée, vers la charge dissipative L10 où ce dernier est absorbé. De même, les produits d'intermodulation dont la fréquence est en dehors de la bande de réception R sont au contraire réfléchis par le premier filtre directif 1 et transmis vers la charge dissipative L11 dans laquelle ces derniers sont dissipés.

On notera bien entendu que le dispositif objet de l'invention représenté en figure 1a permet de mesurer non seulement les produits d'intermodulation passifs engendrés par réflexion, mais également les produits d'intermodulation actifs engendrés par exemple par le récepteur RT dans la mesure où, ces produits d'intermodulation actifs présentent un niveau d'énergie plus important que les produits d'intermodulation passifs.

Un autre mode de réalisation, non limitatif, du dispositif de mesure des produits d'intermodulation d'un système récepteur RE d'au moins deux signaux électromagnétiques d'émission de fréquence différente F1 et F2 sera maintenant donnée, de façon non limitative, en liaison avec la figure 2, ce dispositif dans le mode de réalisation précité étant plus spécialement adapté en vue d'assurer une mesure de produits d'intermodulation en transmission du système récepteur RE.

Sur la figure 2 précitée, on notera que la partie du dispositif relative à la mesure des produits d'intermodulation par réflexion est identique au mode de réalisation de la figure 1a et porte bien les mêmes références. Cependant, afin de ne pas surcharger 1 le dessin, seules les références relatives aux filtres directifs 1, 2 et 3 ont été rappelées, celles relatives aux éléments constitutifs de ces derniers n'ayant pas été reportées au dessin.

Conformément au mode de réalisation de la figure 2, le dispositif objet de l'invention comporte en outre, au moins une voie de réception en transmission VRT et un multiplexeur/démultiplexeur de réception en transmission noté MU-DET. Le multiplexeur/démultiplexeur de réception en transmission est bien entendu un multiplexeur/démultixeur, à filtre directif, ainsi qu'il sera décrit ci-après dans la description.

Le multiplexeur/démultiplexeur MU-DET de réception en transmission sera tout d'abord décrit dans une première variante de réalisation, ainsi que représenté sur la figure 2.

Ainsi que représenté sur cette figure, le multiplexeur-démultiplexeur de réception en transmission MU-DET comporte au moins un quatrième filtre directif 4, passant dans la bande de fréquence T des signaux de produits d'intermodulation en transmission et réflecteur à la fréquence des signaux électromagnétiques transmis, fréquence F1 et F2 et des produits d'intermodulation dont la fréquence se trouve en dehors de la bande passante de transmission T du système récepteur RE.

Ainsi qu'il apparaît en outre en figure 2, le quatrième filtre directif 4 comporte un premier coupleur hybride 410, dont le premier port d'entrée $410_1$ est connecté à une sortie en transmission de produits d'intermodulation notamment du système récepteur RE et dont le deuxième port d'entrée $410_2$ est relié à une charge dissipative L41. Sur la figure 2, on a représenté la liaison entre le deuxième port d'entrée $410_2$ du premier coupleur hybride 410 du quatrième filtre directif 4, en pointillé dans la mesure où, à la charge dissipative L41 précitée, peut être substitué un circuit plus complet, en l'absence de charge dissipative L41, ainsi qu'il sera décrit ultérieurement dans la description. Les ports de sortie $410_3$ et $410_4$ du premier coupleur hybride 410 du quatrième filtre directif 4, sont connectés respectivement à un premier et à un deuxième filtre identiques 41, 42, dont la bande de fréquence transmise est centrée sur la fréquence où la bande de fréquence du système récepteur en transmission, bande de fréquence notée T, du système récepteur RE. Le quatrième filtre directif 4 comporte également un deuxième coupleur hybride 420, dont les ports d'entrée $420_1$ et $420_2$ sont connectés respectivement à une sortie du premier et du deuxième filtre 41, 42 et dont le premier $420_3$ et $420_4$ ports de sortie est relié respectivement à une charge dissipative L40 et à la voie de réception en transmission VRT précitée.

Le fonctionnement du multiplexeur/démultiplexeur de réception en transmission MU-DET, de manière analogue au mode de réalisation de la figure 1a, est le suivant :

– la sortie du système récepteur RE délivrant les signaux en transmission délivre des signaux électromagnétiques de fréquence F1,F2 et des signaux de produits d'intermodulation en transmission, dont la fréquence tombe dans la bande de fréquence en transmission du récepteur RE à tester, et d'autres produits d'intermodulation notés PIMPT dont la fréquence se trouve en dehors de la bande de fréquence de réception en transmission du système récepteur RE. Le filtre directif 4 permet la seule transmission des signaux électromagnétiques produits d'intermodulation dont la fréquence tombe dans la bande de fréquence de réception en transmission du récepteur RE, les autres signaux électromagnétiques précités étant réfléchis par les filtres 41 et 42 du filtre directif 4 et transmis vers la charge dissipative KL41, dans laquelle ces derniers sont dissipés. Les signaux électromagnétiques produits d'intermodulation dont la fréquence tombe dans la bande de fréquence en réception T du récepteur RE transmis par le filtre directif 4, sont alors transmis à la voie de réception en transmission VRT, vers l'appareil de mesure AM précité.

De meilleures performances du dispositif de mesure des produits d'intermodulation par transmission, tels que représentés en figure 2 peuvent être obtenus si l'on dissipe séparément les signaux électromagnétiques de fréquence F1 et F2 transmis et les produits d'intermodulation, dont la fréquence est en dehors de la bande de fréquence de réception en transmission T.

Dans ce but, ainsi que représenté également en figure 2, à la charge dissipative L41 peut être substitué un circuit spécialisé complétant le multiplexeur/démultiplexeur de réception en transmission MU-DET précité.

Dans le but de constituer le circuit spécialisé précédemment mentionné, celui-ci est constitué également par des filtres directifs supplémentaires. Le multiplexeur/démultiplexeur de réception en transmission comporte en outre un cinquième filtre directif 5 passant dans la bande de fréquence F1 correspondant à la première fréquence d'émission F1 et réflecteur dans toutes les autres bandes de fréquence considérée des signaux électromagnétiques reçus en transmission. Il comporte également un sixième filtre directif 6 passant dans la bande de fréquence F2 correspondant à la deuxième fréquence d'émission F2 et réflecteur dans toutes les autres bandes de fréquence des signaux électromagnétiques reçus en transmission.

Afin de constituer le cinquième filtre directif 5, ainsi que représenté en figure 2, celui-ci peut comprendre un premier coupleur hybride 510 dont le premier port d'entrée $510_1$ est connecté au deuxième port d'entrée $410_2$ du premier circuit hybride 410 du quatrième filtre directif, la charge dissipative L41 étant supprimée. Le cinquième filtre directif 5 comporte en outre deux filtres identiques 51,52 dont la bande passante est centrée sur la fréquence F1, ces filtres étant connectés respectivement au premier et deuxième port d'entrée $510_3$ et $510_4$ du premier coupleur hybride 510. Le cinquième filtre directif 5 comporte enfin un deuxième coupleur hybride 520 dont les ports d'entrée $520_1$ et $520_2$ sont connectés respectivement à une sortie de chaque filtre identique et dont les ports de sortie $520_3$ et $520_4$ sont respectivement connectés à une charge dissipative notée L50 et L51.

De manière analogue, ainsi que représenté en figure 2, le sixième filtre directif 6 comporte, avantageusement, un premier coupleur hybride 610 dont le premier port d'entrée $610_1$ est connecté au deuxième port d'entrée $510_2$ du premier coupleur hybride 510 du cinquième filtre directif 5, et dont le deuxième port d'entrée $610_2$ est connecté à une charge dissipative L62. Le zixième filtre directif 6 comporte également deux filtres identiques 61,62, dont la bande passante est centrée sur la fréquence F2, ces filtres identiques 61,62 étant connectés respectivement au premier et au deuxième port de sortie $610_3$, $610_4$ du premier coupleur hybride 610. Le filtre directif 6 constituant sixième filtre directif comporte également un deuxième coupleur hybride 620, dont les ports d'entrée $620_1$ et $620_2$ sont respectivement connectés à une sortie de chacun des deux filtres identiques 61,62 et dont les ports de sortie $620_3$ et $620_4$ sont eux-mêmes respectivement connectés à une charge dissipative L60 et L61.

On comprendra bien entendu que le cinquième filtre directif 5 transmettant le signal électromagnétique de fréquence F1, celui-ci est transmis vers la charge dissipative L51 dans laquelle il est dissipé. Au contraire, les autres signaux électromagnétiques de fréquence différente reçus en transmission sont réfléchis par le cinquième filtre directif 5, et transmis vers le sixième filtre directif 6. Celui-ci permettant la transmission du signal électromagnétique de fréquence F2 reçu en transmission, conduit celui-ci vers la charge dissipative L61, dans laquelle il est à son tour dissipé.

Les signaux électromagnétiques produits d'intermodulation dont la fréquence est en dehors de la bande passante de réception en transmission T sont réfléchis par le sixième filtre directif 6 et transmis vers la charge dissipative L62, dans laquelle ils sont également dissipés.

Bien entendu, les filtres identiques respectivement 41,42, 51,52 et 61,62 peuvent être constitués de manière analogue aux filtres identiques 11, 12, 21, 22, 31,32 précédemment décrits, la fréquence centrale des bandes de transmission des filtres étant évidemment adapté en conséquence si nécessaire.

Afin de faciliter la mise en oeuvre du dispositif objet de l'invention, tel que réalisé soit en figure la ou en figure 2, les voies d'émission VE1, VE2, la voie de réception en réflexion VRR et la voie de réception en transmission VRT peuvent comporter des moyens de filtrage et des moyens d'amplification du signal filtré. Les moyens de filtrage sont notés respectivement sur les figures 1a et 2, 70,80,90 et 100. Ils peuvent de manière avantageuse être constitués par des filtres en peigne de technologie classique. Cependant, afin de réduire au maximum les produits d'intermodulation susceptibles d'être engendrés par le dispositif de mesure lui-même, il sera avantageux, pour la réalisation des filtres précités notamment, de constituer ceux-ci au moyen de cavités résonnantes présentant des doigts imbriqués, le matériau constitutif, tant des parois de la cavité résonnante que des doigts étant avantageusement constitué par un revêtement en métal noble, tel que de l'or ou de l'argent. On a constaté en effet que l'utilisation des métaux nobles en lieu et place de métaux traditionnels comme le nickel ou l'aluminium permettaient de réduire sensiblement le niveau des signaux électromagnétiques d'intermodulation engendrés par le dispositif de mesure lui-même.

En outre, dans le cas où le dispositif objet de l'invention tel que représenté en figures 1a et 2 est destiné à effectuer des mesures pour des fréquences d'émission F1, F2 inférieures à environ 1000 MHz, l'interconnexion notée IC sur les figures 1a et 2 des différents éléments peut être effectuée avantageusement au moyen de câbles coaxiaux. Au contraire, lorsque le dispositif de mesure objet de l'invention est destiné à être utilisé pour des fréquences d'émission supérieures à 1200 MHz, l'interconnexion IC des différents éléments pourra avantageusement être effectuée en guide d'onde soudé, afin d'assurer de meilleures conditions de propagation des signaux, en l'absence de risques de produits d'intermodulation supplémentaires engendrés par le dispositif de mesure lui-même.

En outre et de manière classique, les moyens amplificateurs notés 71, 81, 91 et 101, peuvent être réalisés par des amplificateurs accordés sur les fréquences correspondantes des voies de transmission précitées et la liaison notamment des filtres 70, 80, 90 et 100 peut être assurée par l'intermédiaire d'isolateurs constitués par des circulateurs, ainsi que représenté schématiquement sur la figure 1a notamment. Ces éléments ne seront pas décrits car ils font partie des dispositifs connus de l'état de la technique des hyperfréquences.

En outre, afin d'assurer une meilleure souplesse d'utilisation du dispositif de mesure des produits d'intermodulation objet de l'invention, la voie de réception en réception VRR, la voie de réception en transmission VRT peuvent être connectées à l'appareil de mesure AM par l'intermédiaire d'un commutateur 200. Le commutateur 200 de type classique ne sera pas décrit, celui-ci pouvant consister en un dispositif à Té magique ou analogue.

On a ainsi décrit un dispositif de mesure de produits d'intermodulation d'un système récepteur, d'au moins deux signaux électromagnétiques d'émission de fréquence différente, particulièrement avantageux. En effet, en raison du caractère modulaire du dispositif objet de l'invention décrit en relation avec les figures 1a et 2, il est bien entendu possible d'étendre le mode opératoire du dispositif précité à un nombre de canaux d'émission et de réception quelconque, un nombre quelconque de fréquence d'émission pouvant être envisagé et un nombre correspondant de voies de réception, tant au niveau du multiplexeur-démultiplexeur MU-DER de réception en réflexion que du multiplexeur-démultiplexeur MU-DET de réception en transmission pouvant être envisagé ces voies pouvant être accordées sur des bandes de fréquence différente. En effet, ainsi qu'on le comprendra aisément, cette modification peut être effectuée par seule adjonction d'une voie d'émission ou de réception correspondante à laquelle est bien entendu associé un filtre directif de fréquence adaptée.

En outre, l'intérêt du dispositif de mesure objet de l'invention apparaît notamment, compte tenu du fait que les filtres sont traversés par au plus un seul signal de forte puissance, ces signaux pouvant atteindre les puissances de l'ordre de 10 Watts, ce qui élimine une possibilité importante de création de produits d'intermodulation passifs ou actifs par le banc lui-même.

On notera en outre que, les voies précédemment décrites et leur filtre directif associé peuvent être agencés dans un ordre quelconque, sans difficulté. L'addition des signaux de forte puissance, signaux électromagnétiques d'émission de fréquence F1 et F2, se fait par réflexion sur les filtres du filtre directif, premièrement rencontrés, de rang supérieur, le filtre directif 2 dans le cas de la figure 1 et de la figure 2, dans le coupleur hybride correspondant et dans la ligne de transmission au moyen d'interconnexion IC interconnectée au système récepteur RE à tester. Les éléments concernés sont simples et peuvent être fabriqués de façon à minimaliser les produits d'intermodulation qu'ils sont susceptibles eux-mêmes d'engendrer. Dans le cas où la puissance des signaux électromagnétiques d'émission de fréquence F1 et F2 est faible, une réalisation des interconnexions en câble coaxial peut être suffisante.

En outre, le dispositif de mesure objet de l'invention est adapté à toutes les fréquences lorsque celui-ci est vu à partir de son accès vers l'appareil de mesure AM. Celui-ci peut d'ailleurs être avantageusement constitué par un analyseur de spectre. Ceci permet d'assurer qu'aucune surtension ne viendra perturber les mesures en modifiant les valeurs des produits d'intermodulation mesurés directement ou par l'intermédiaire des produits d'intermodulation non mesurés, c'est-à-dire dont la fréquence tombe en dehors de la bande de fréquence de réceppion par réflexion ou par transmission. Les signaux de forte puissance réfléchis par le système récepeur RE testé, sont dissipés chacun séparément dans les charges des circuits isolateurs ou dans les amplificateurs de puissance des voies d'émission VT1 et VT2, ce qui garantit qu'ils ne créeront pas de nouveaux produits d'intermodulation.

Les produits d'intermodulation non mesurés, c'est-à-dire dont la fréquence tombe en dehors de la bande de fréquence de réception par réflexion ou par transmission précitée sont dissipés dans des charges séparées ainsi que précédemment décrit, afin qu'ils ne perturbent pas la mesure.

Dans le mode de réalisation préférentiel de la figure 2, les signaux de forte puissance, les signaux d'émission de fréquence F1 et F2 et les produits d'intermodulation non mesurés transmis sont, de manière beaucoup plus avantageuse, dissipés dans des charges séparées afin qu'ils ne perturbent pas la mesure. On notera enfin que dans le cas de la figure 2, les charges dissipatives L51 et L61 sont constituées par des charges de puissance, ainsi bien entendu que la charge dissipative L62, les charges L40, L50, L60, étant au contraire plutôt constituées par des charges permettant de réaliser l'adaptation d'impédance des circuits hybrides correspondants.

## Revendications

1. Dispositif de mesure de produits d'intermodulation d'un système récepteur (RE) d'au moins deux signaux électromagnétiques d'émission de fréquence différente (F1,F2) caractérisé en ce que ledit dispositif comporte :
  - au moins deux voies d'émission (VE1,VE2) desdits signaux électromagnétiques d'émission, chaque voie permettant la transmission d'un desdits signaux de fréquence (F1) ou (F2);
  - une voie de réception en réflexion (VRR) connectée à un appareil de mesure (AM) des produits d'intermodulation, ladite voie de réception permettant la transmission de signaux électromagnétiques dans une bande de fréquence centrée sur la bande de fréquence de réception dudit système récepteur (RE),
  - un multiplexeur/démultiplexeur de réception en réflexion (MU-DER) à filtres directifs (1,2,3) dont les entrées/sorties sont respectivement connectées à ladite première et deuxième voie d'émission (VE1,VE2), à la voie de réception en réflexion (VRR) et audit système récepteur (RE), ledit multiplexeur/démultiplexeur comportant un filtre directif (1,2,3) associé à chaque voie, chacun desdits filtres directifs (1,2,3) étant passant à la fréquence des signaux électromagnétiques transmis par la voie à laquelle celui-ci est associé et réflecteur à la fréquence des signaux électromagnétiques des autres voies et des produits d'intermodulation situés en dehors de la bande de fréquence de réception.

2. Dispositif selon la revendication 1, caractérisé en ce que lesdits filtres directifs (1,2,3) sont constitués par :
  - un premier (110) coupleur hybride dont le premier port d'entrée ($110_1$) reçoit le signal électromagnétique de fréquence correspondant à la fréquence de la voie considérée,
  - deux filtres identiques (11,,12) permettant la transmission de signaux électromagnétiques dans une bande de fréquence centrée sur la fréquence de la voie considérée, chaque filtre (11,12) étant connecté respectivement au port de sortie ($110_3$, $110_4$) du premier coupleur hybride (110),
  - un deuxième (120) coupleur hybride dont chaque port d'entrée ($120_1$, $120_2$) est connecté à la sortie d'un des deux filtres identiques (11,12) et dont le deuxième port de sortie ($120_4$) délivre le signal électromagnétique de fréquence correspondant à la fréquence de la voie considérée et dont le premier port de sortie ($120_3$) est connecté soit à une première charge dissipative (L11) soit au deuxième port de sortie du deuxième coupleur (120) hybride d'un autre filtre directif, le deuxième port d'entrée du premier (110) coupleur hybride étant connecté soit à une deuxième charge dissipative (L10) soit au deuxième port de sortie du deuxième (120) coupleur hybride d'un autre filtre directif.

3. Dispositif selon la revendication 2, caractérisé en ce que, en vue d'assurer une mesure de produits d'intermodulation en réflexion dudit système récepteur (RE) pour deux signaux électromagnétiques d'émission de fréquence différente (F1,F2)
  - le premier ($110_1$) et le deuxième ($110_2$) port d'entrée du premier coupleur hybride (110) du premier filtre directif (1) sont respectivement connectés à la première voie d'émission (VE1) et à la deuxième charge dissipative (L10), le premier port de sortie ($120_3$) du deuxième coupleur hybride (120) dudit premier filtre directif (1) étant connecté à la première charge dissipative (L11),
  - le premier ($220_1$) et le deuxième ($210_2$) port d'entrée du premier coupleur hybride (210) du deuxième filtre directif (2) sont respectivement connectés à la deuxième voie d'émission (VE2) et à une troisième charge dissipative (L20), le premier port de sortie ($220_3$) du deuxième coupleur hybride (220) du deuxième filtre directif (2) étant connecté au deuxième port de sortie ($120_4$) du deuxième coupleur hybride (120) du premier filtre directif (1),
  - le premier ($310_1$) et le deuxième ($310_2$) port d'entrée du premier coupleur hybride (310) du troisième filtre directif (3) sont respectivement connectés au système récepteur (RE) à tester et au deuxième port de sortie ($220_4$) du deuxième coupleur hybride (220) du deuxième filtre directif (2), le premier ($320_3$) et le deuxième ($320_4$) port de sortie du deuxième coupleur hybride (320) du troisième filtre directif (3) étant respectivement connectés à la voie de réception en réflexion (VRR) et à une charge quatrième dissipative (L30).

4. Dispositif selon la revendication 2, caractérisé en ce que, en vue d'assurer une mesure de produits d'intermodulation en transmission dudit système récepteur (RE) pour deux signaux électromagnétiques d'émission de fréquence différente (F1 et F2) ledit dispositif comporte en outre au moins une voie de réception (VRT) en transmission, et un multiplexeur/démultiplexeur à filtres directifs de réception en transmission (MU-DET).

5. Dispositif selon la revendication 4, caractérisé en ce que ledit multiplexeur/démultiplexeur à filtres directifs de réception en transmission (MU-DET) comporte au moins un quatrième filtre directif (4) passant dans la bande de fréquence (T) des signaux de produits d'intermodulation en transmission et réflecteur à la fréquence des signaux transmis (F″1,F″2) et des produits d'intermodulation en dehors de la bande de transmission (T).

6. Dispositif selon la revendication 5, caractérisé en ce que ledit quatrième filtre directif (4) comporte :

– un premier coupleur hybride (410) dont le premier port d'entrée (410₁) est connecté à une sortie de produits d'intermodulation du système récepteur (RE) et dont le deuxième port d'entrée (410₂) est relié à une cinquième charge dissipative (L41), les ports de sortie du premier coupleur hybride (410) étant connectés respectivement à un premier filtre (41) et à un deuxième filtre (42) identiques dont la bande de fréquence transmise est centrée sur la fréquence ou bande de fréquence (T) en transmission du système récepteur (RE),

– un deuxième coupleur hybride (420) dont les ports d'entrée (420₁), (420₂) sont connectés respectivement à une sortie dudit premier et deuxième filtre (41,42) et dont le premier (420₃) et le deuxième (420₄) port de sortie est relié respectivement à une sixième charge dissipative (L40) et à ladite voie de réception en transmission (VRT).

7. Dispositif selon l'une des revendications 5 ou 7, caractérisé en ce que ledit multiplexeur/démultiplexeur à filtres directifs de réception (MU-DET) en transmission comporte en outre :

– un cinquième filtre directif (5) passant dans la bande de fréquence (F″1) correspondant à la première fréquence d'émission (F1) et réflecteur dans toutes les autres bandes de fréquence,

– un sixième filtre directif (6) passant dans la bande de fréquence (F″2) correspondant à la deuxième fréquence d'émission (F2) et réflecteur dans toutes les autres bandes de fréquence.

8. Dispositif selon la revendication 7, caractérisé en ce que ledit cinquième (5) et sixième (6) filtre directif formant ledit cinquième filtre directif (5) comprend :

– un premier coupleur hybride (510) dont le port d'entrée (510₁) est connecté au deuxième port d'entrée (410₂) du premier circuit hybride (410) du quatrième filtre directif (4), la cinquième charge dissipative (L41) étant supprimée

– deux filtres identiques (51,52) dont la bande passante est centrée sur la fréquence (F″1) connectés respectivement au premier et deuxième port d'entrée (10₃, 510₄) dudit premier coupleur hybride,

– un deuxième coupleur hybride (520) dont les ports d'entrée (520₁, 520₂) sont connectés respectivement à une sortie de chaque filtre identique et dont les ports de sortie (520₃, 520₄) sont eux-mêmes respectivement connectés à une septième et une huitième charge dissipative (L50,L51) formant ledit sixième filtre directif (6) ;

– un premier coupleur hybride (610) dont le premier port d'entrée (610₁) est connecté au deuxième port d'entrée (510₂) du premier coupleur hybride (510) dudit cinquième filtre directif ((), et dont le deuxième port d'entrée (610₂) est connecté à une neuvième charge dissipative (L62),

– deux filtres identiques (61,62) dont la bande passante est centrée sur la fréquence (F″2) connectés respectivement au premier et au deuxième port de sortie (610₃, 610₄) dudit premier coupleur hybride (610),

– un deuxième coupleur hybride (620) dont les ports d'entrée (620₁, 620₂) sont respectivement connectés à une sortie de chacun des deux filtres identiques (61,62) et dont les ports de sortie (620₃, 620₄) sont eux-mêmes respectivement connectés à une dixième et une onzième charge dissipative (L60,L61).

9. Dispositif selon l'une des revendications précédentes, caractérisé en ce que lesdites voies d'émission (VE1,VE2), ladite voie de réception en réflexion (VRR) et ladite voie de réception en transmission (VRT), comprenant des moyens de filtrage et des moyens d'amplification du signal filtré.

10. Dispositif selon la revendication 9, caractérisé en ce que lesdits moyens de filtrage (70,80,90,100) sont constitués par un filtre en peigne.

11. Dispositif selon l'une des revendications 1 à 10, caractérisé en ce que pour des fréquences d'émission (F1,F2) inférieures à environ 1000 MHz, l'interconnexion (IC) des différents éléments est effectuée au moyen de câbles coaxiaux.

12. Dispositif selon l'une des revendications 1 à 10, caractérisé en ce que pour des fréquences d'émission supérieures à 1200 MHz, l'interconnexion (IC) des différents éléments est effectuée en guide d'ondes.

13. Dispositif selon l'une des revendications précédentes, caractérisé en ce que la voie de réception en réflexion (VRR) et la voie de réception en transmission (VRT) sont connectées audit appareil de mesure (AM) par l'intermédiaire d'un commutateur (200).

14. Utilisation d'un dispositif de mesure selon l'une des revendications précédentes pour la mesure des produits d'intermodulation d'un récepteur tel qu'une antenne de récepteur radar ou de télécommunication par satellite.

**Patentansprüche**

1. Meßvorrichtung für Intermodulationsprodukte eines Empfangssystems (RE) aus wenigstens zwei elektromagnetischen Sendesignalen unterschiedlicher Frequenz (F1, F2) dadurch gekennzeichnet, daß die Vorrichtung enthält:

– Wenigstens zwei Sendekanäle (VE1, VE2) für die elektromagnetischen Sendesignale, von denen jeder Kanal die Übertragung eines der genannten Signale der Frequenz (F1) oder (F2) erlaubt;

– einen Reflexionsempfangskanal (VRR), der mit einer Meßvorrichtung (AM) für Intermodulationsprodukte verbunden ist, wobei dieser Empfangskanal die Übertragung elektromagnetischer Signale in einem Frequenzband erlaubt, das auf das Empfangsfrequenzband des genannten Empfangssystems (RE) zentriert ist,

– einen Reflexionsempfangsmultiplexer/Demultiplexer (MU-DER) mit Richtungsfiltern (1, 2, 3), deren Eingänge/Ausgänge mit dem ersten und zweiten Sendekanal (VE1, VE2), dem Reflexionsempfangskanal (VRR) bzw. im Empfangssystem (RE) verbunden sind, wobei der Multiplexer/Demultiplexer ein jedem Kanal zugeordnetes Richtungsfilter (1, 2, 3) enthält, jedes der Richtungsfilter (1, 2, 3) für die Frequenz der elektromagnetischen Signale durchlässig ist, die von dem Kanal übertragen werden, dem es zugeordnet ist, und bei der Frequenz der elektromagnetischen Signale der anderen Kanäle und der Intermodulationsprodukte, die außerhalb des Empfangsfrequenzbandes liegen, reflektierend ist.

2. Vorrichtung nach Anspruch 1, dadurch gekennzeichnet, daß die Richtungsfilter (1, 2, 3) gebildet sind durch:

– einen ersten Hybridkoppler (110), dessen erster Eingang ($110_1$) das elektromagnetische Material der Frequenz aufnimmt, die der Frequenz des betreffenden Kanals entspricht,

– zwei identische Filter (11, 12), die die Übertragung elektromagnetischer Signale in einem Frequenzband erlauben, das auf die Frequenz des betreffenden Kanals zentriert ist, wobei jedes Filter (11, 12) mit dem Ausgang ($110_3$, $110_4$) des ersten Hybridkopplers (110) jeweils verbunden ist,

– einen zweiten Hybridkoppler (120), von dem jeder Eingang ($120_1$, $120_2$) mit dem Ausgang einer der zwei identischen Filter (11, 12) verbunden ist und dessen zweiter Ausgang ($120_4$) das elektromagnetische Signal der Frequenz liefert, die der Frequenz des betreffenden Kanals entspricht, und von dem der erste Ausgang ($120_3$) mit entweder einer ersten Last ($L_{11}$) oder mit dem zweiten Ausgang des ersten Hybridkopplers (120) eines anderen Richtungsfilters verbunden ist, wobei der zweite Eingang des ersten Hybridkopplers (110) verbunden ist entweder mit einer zweiten Last ($L_{10}$) oder einem zweiten Ausgang des zweiten Hybridkopplers (120) eines anderen Richtungsfilters.

3. Vorrichtung nach Anspruch 2, dadurch gekennzeichnet, daß zur Erzielung einer Messung von Intermodulationsprodukten in Reflexion des Empfangssystems (RE) für zwei elektromagnetische Sendesignale unterschiedlicher Frequenz (F1, F2)

– der erste ($110_1$) und der zweite ($110_2$) Eingang des ersten Hybridkopplers (110) des ersten Richtungsfilters (1) jeweils mit dem ersten Sendekanal (VE1) mit der zweiten Last (L10) verbunden sind, der erste Ausgang ($120_3$) des zweiten Hybridkopplers (120) des ersten Richtungsfilters (1) mit der ersten Last (L11) verbunden ist,

– der erste ($220_1$) und der zweite ($210_2$) Eingang des ersten Hybridkopplers (210) des zweiten Richtungsfilters (2) mit dem zweiten Sendekanal (VE2) bzw. einer dritten Last (L20) verbunden sind, der erste Ausgang ($220_3$) des zweiten Hybridkopplers (220) des zweiten Richtungsfilters (2) mit dem zweiten Ausgang ($120_4$) des zweiten Hybridkopplers (120) des ersten Richtungsfilters (1) verbunden ist,

– der erste ($310_1$) und der zweite ($310_2$) Eingang des ersten Hybridkopplers (310) des dritten Richtungsfilters (3) mit dem zu prüfenden Empfangssystem (RE) bzw. dem zweiten Ausgang ($220_4$) des zweiten Hybridkopplers (220) des zweiten Richtungsfilters (2) verbunden sind, der erste ($320_3$) und der zweite ($320_4$) Ausgang des zweiten Hybridkopplers (320) des dritten Richtungsfilters (3) im Reflexionsempfangskanal (VRR) bzw. einer vierten Last (L30) verbunden sind.

4. Vorrichtung nach Anspruch 2, dadurch gekennzeichnet, daß zur Erzielung einer Messung von Intermodulationsprodukten in Duchgang des Empfangssystems (RE) für elektromagnetische Sendesignale unterschiedlicher Frequenz (F1 und F2) die Vorrichtung darüber hinaus wenigstens einen Durchlaffempfangskanal (VRT) und einen Multiplexer/Demultiplexer mit Empfangs-Duchlaß-Richtungsfiltern (MU-DET) aufweist.

5. Vorrichtung nach Anspruch 4, dadurch gekennzeichnet, daß der Multiplexer/Demultiplexer mit Empfangs-Durchlaß-Richtungsfiltern (MU-DET) wenigstens ein viertes Richtungsfilter (4) aufweist, das im Frequenzband (T) der Signale von Intermodulationsprodukten durchlässig ist und bei der Frequenz der übertragenen Signale (F″1, F″2) und der Intermodulationsprodukte außerhalb des Sendebands (T) reflektierend ist.

6. Vorrichtung nach Anspruch 5, dadurch gekennzeichnet, daß das vierte Richtungsfilter (4) enthält:

– einen ersten Hybridkoppler (410), dessen erster Eingang ($410_1$) mit einem Ausgang für Intermodulationsprodukte des Empfangssystems (RE) verbunden ist und dessen zweiter Eingang ($410_2$) mit einer fünften Last (L41) verbunden ist, die Ausgänge des ersten Hybridkopplers (410) mit einem ersten Filter (41) bzw.

einem identischen zweiten Filter (42) verbunden sind, deren Durchlaßfrequenzband auf die Frequenz oder das Durchlaßfrequenzband (T) des Empfangssystems (RE) zentriert ist,

– einen zweiten Hybridkoppler (420), dessen Eingänge ($420_1$, $420_2$) jeweils mit einem Ausgang des ersten und zweiten Filters (41, 42) verbunden sind und von dem der erste ($420_3$) und der zweite ($420_4$) Ausgang jeweils mit einer sechsten Last (L40) und dem Empfangskanal in Durchlaß (VRT) verbunden sind.

7. Vorrichtung nach einem der Ansprüche 5 oder 7, dadurch gekennzeichnet, daß der Multiplexer/Demultiplexer mit Empfangsrichtungsfiltern (MU-DET) in Durchlaß weiterhin enthält:

– ein fünftes Richtungsfilter (5), das im Frequenzband (F″1) durchlässig ist, das der ersten Sendefrequenz (F1) entspricht, und in allen anderen Frequenzbändern reflektierend ist,

– ein zweites Richtungsfilter (6), das im Frequenzband (F″2) durchlässig ist, das der zweiten Sendefrequenz (F2) entspricht, und in allen anderen Frequenzbändern reflektierend ist.

8. Vorrichtung nach Anspruch 7, dadurch gekennzeichnet, daß das fünfte (5) und das sechste (6) Richtungsfilter, das das fünfte Richtungsfilter (5) bildet, enthält:

– einen ersten Hybridkoppler (510), dessen Eingang ($510_1$) mit dem zweiten Ausgang ($410_2$) der ersten Hybridschaltung (410) des vierten Richtungsfilters (4) verbunden ist, wobei die fünfte Last (L41) unterdrückt ist,

– zwei identische Filter (51, 52), deren Durchlaßband auf die Frequenz (F″1) zentriert ist, und die mit dem ersten bzw. zweiten Eingang ($10_3$, $510_4$) des ersten Hybridkopplers verbunden sind,

– einen zweiten Hybridkoppler (520), dessen Eingänge ($520_1$, $520_2$) jeweils mit einem Ausgang jedes identischen Filters verbunden sind und dessen Ausgänge ($520_3$, $520_4$) ihrerseits jeweils mit einer siebten und einer achten Last (L50, L51) verbunden sind, das sechste Richtungsfilter (6) bildend:

– einen ersten Hybridkoppler (610), dessen erster Eingang ($610_1$) mit dem zweiten Eingang ($510_2$) des ersten Hybridkopplers (510) des fünften Richtungsfilters (5) verbunden ist und dessen zweiter Eingang ($610_2$) mit einer neunten Last (L62) verbunden ist,

– zwei identische Filter (61, 62) deren Durchlaßband auf die Frequenz (F″2) zentriert ist und die mit dem ersten bzw. zweiten Ausgang ($610_3$, $610_4$) des ersten Hybridkopplers (610) verbunden sind,

– einen zweiten Hybridkoppler (620), dessen Eingänge ($620_1$, $620_2$) jeweils mit einem Ausgang jedes der beiden identischen Filter (61, 62) verbunden sind und deren Ausgänge ($620_3$, $620_4$)

ihrerseits jeweils mit einer zehnten bzw. einer elften Last (L60, L61) verbunden sind.

9. Vorrichtung nach einem der vorhergehenden Ansprüche, dadurch gekennzeichnet, daß die Sendekanäle (VE1, VE2), der Reflexionsempfangskanal (VRR) und der genannte Empfangskanal in Durchlaß (VRT) Filtereinrichtungen und Verstärkereinrichtungen für das gefilterte Signal enthalten.

10. Vorrichtung nach Anspruch 9, dadurch gekennzeichnet, daß die Filtereinrichtungen (70, 80, 90, 100) von einem Kammfilter gebildet sind.

11. Vorrichtung nach einem der Ansprüche 1 bis 10, dadurch gekennzeichnet, daß für Sendefrequenzen (F1, F2), die unter etwa 1000 MHz liegen, die gegenseitige Verbindung (IC) der verschiedenen Elemente mittels Koaxialkabeln ausgeführt ist.

12. Vorrichtung nach einem der Ansprüche 1 bis 10, dadurch gekennzeichnet, daß für Sendefrequenzen über 1200 MHz die gegenseitige Verbindung (IC) der verschiedenen Elemente mit Wellenleitern ausgeführt ist.

13. Vorrichtung nach einem der vorhergehenden Ansprüche, dadurch gekennzeichnet, daß der Empfangskanal in Reflexion (VRR) und der Empfangskanal in Durchlaß (VRT) mit der Meßvorrichtung (AM) über einen Schalter (200) verbunden sind.

14. Verwendung einer Meßvorrichtung nach einem der vorhergehenden Ansprüche für die Messung von Intermodulationsprodukten eines Empfängers, wie beispielsweise einer Radarempfangsantenne oder einer Satellitentelekommunikationsantenne.

## Claims

1. A device for the measurement of intermodulation products of a receiver system (RE) of at least two transmitted electromagnetic signals of different frequences (F1,F2) said device comprising :

– at least two transmission channels (VE1,VE2) for said transmitted electromagnetic signals, each channel enabling the transfer of one of said signals of different frequencies (F1) or (F2);

– a reflective reception channel (VRR) connected to an apparatus (AM) for the measurement of intermodulation products, said reception channel enabling the transfer of electromagnetic signals in a frequency band centered on the reception frequency band of said receiver (RE);

– reflective reception multiplexer/demultiplexer (MU-DER) with directional filters (1,2,3), the inputs/ outputs of which are respectively connected to said first and second transmission channels (VE1,VE2), to the reflective reception channel (VRR) and to said receiver system (RE), said multiplexer/demultiplexer comprising a directional filter (1,2,3) associated with each channel, each of said directional filters (1,2,3) transmitting at the frequency of the electromagnetic signals transferred by the channel with which it is associated and being reflective at the frequency of the electromagnetic signals of the other channels and of the intermodulation products located outside the reception frequency band.

2. A device according to claim 1, wherein said directional filters (1,2,3) are constituted by :

– a first hybrid coupler (110), the first input port $(110_1)$ of which receives the electromagnetic signal of a frequency corresponding to the frequency of the channel considered;

– two identical filters (11,12) enabling the transfer of electromagnetic signals in a frequency band centered on the frequuency of the channel considered, each filter (11,12) being connected respectively to the output port $(110_3, 110_4)$ of the first hybrid coupler (110);

– a second hybrid coupler (120), each input port $(120_1, 120_2)$ of which is connected to the output of one of the two identical filters (11,12), and the second output port $(120_4)$ of which delivers the electromagnetic signal of a frequency corresponding to the frequency of the channel considered, and the first output port $(120_3)$ of which is connected either to a first dissipative load (L11) or to the second output port of the second hybrid coupler (120) of another directional filter, the second input port of the first hybrid coupler (110) being connected either to a second dissipative load (L10) or to the second output port of the second hybrid coupler (120) of another directional filter.

3. A device according to claim 2, wherein, in order to ensure a measurement of reflective intermodulation products of said receiver system (RE) for two transmitted electromagnetic signals of different frequencies (F1,F2);

– the first $(110_1)$ and second $(110_2)$ input ports of the first hybrid coupler (110) of the first directional filter (1) are respectively connected to the first transmission channel (VE1) and to the second dissipative load (L10), the first output port $(120_3)$ of the second hybrid coupler (120) of said first directional filter (1) being connected to the first dissipative load (L11);

– the first $(220_1)$ and second $(210_2)$ input ports of the first hybrid coupler (210) of the second directional filter (2) are respectively connected to the second transmission channel (VE2) and to a third dissipative load (L20), the first output port $(220_3)$ of the second hybrid coupler (220) of the second directional filter (2) being connected to the second output port $(120_4)$ of the second hybrid coupler (120) of the first directional filter (1);

– the first $(310_1)$ and second $(310_2)$ input ports of the first hybrid coupler (310) of the third directional filter (3) are respectively connected to the receiver system (RE) to be tested and at the second output port $(220_4)$ of the second hybrid coupler (220) of the second directional filter (2), the first $(320_3)$ and second $(320_4)$ output ports of the second hybrid coupler (320) of the third directional filter (3) being respectively connected to the reflective reception channel (VRR) and to a fourth dissipative load.

4. A device according to claim 2, wherein, in order to ensure a measurement of transferred intermodulation products of said receiver system (RE) for two transmitted electromagnetic signals of different frequencies (F1 and F2), said device further comprises a transfer reception channel (VRT) and a transfer reception multiplexer/demultiplexer (MU-DET) with directional filters.

5. A device according to claim 4, wherein said transfer reception multiplexer/demultiplexer (MU-DET) with directional filters has at least one fourth directional filter (4) which transmits in the frequency and (T) of the transferred intermodulation product signals and is reflective at the frequency(F″1,F″2) of the transferred signals and of the intermodulation products outside the transfer band (T).

6. A device according to claim 5, wherein said fourth directional filter (4) comprises :

– a first hybrid coupler (410), the first input port $(410_1)$ of which is connected to an output of intermodulation products of the receiver system (RE), and the second input port $(410_2)$ of which is connected to a fifth dissipative load (L41), the output ports of the first hybrid coupler (410) being connected respectively to a first filter (41) and a second filter (42), identical to each other, the transferred frequency band of which is centered on the transfer frequency band (T) or frequency of the receiver system (RE);

– a second hybrid coupler (420), the input ports $(420_1, 420_2)$ of which are respectively connected to an output of said first and second filters (41,42), and the first $(420_3)$ and second $(420_4)$ output port of which are respectively connected to a sixth dissipative load (L40) and to said transfer reception channel (VRT).

7. A device according to claim 5 or 7 wherein said transfer reception multiplexer/demultiplexer (MU-DET) with directional filters further comprises :

– a fifth directional filter (5) which transmits in the frequency band (F″1) corresponding to the first transmission frequency (F1) and is reflective in all the other frequency bands;

– a sixth directional filter (6) which transmits in the frequency band (F″2) corresponding to the second transmission frequency (F2) and is reflective in all the other frequency bands.

8. A device according to claim 7, wherein said fifth (5) and sixth (6) directional filters forming said fifth (5) directional filter comprises :

– a first hybrid coupler (510), the input port ($510_1$) of which is connected to the second input port ($410_2$) of the first hybrid circuit (410) of the fourth directional filter (4), the fifth dissipative load (L41) being eliminated;

– two identical filters (51,52), the pass-band of which is centered on the frequency band (F"1), corresponding to the first transmission frequency, respectively connectdd to the first ($510_3$) and second ($510_4$) input ports of said first hybrid coupler;

– a second hybrid coupler (520), the input ports ($520_1$,$520_2$) of which are respectively connected to an output of each identical filter and the output ports ($520_3$,$520_4$) of which are themselves respectively connected to a seventh (L50) and a eighth (L51) dissipative load forming said sixth directional filter (6) ;

– a first hybrid coupler (610), the first input port ($610_1$) of which is connected to the second input port ($510_2$) of the first hybrid coupler (510) of said fifth directional filter (5), and the second input port ($610_2$) of which is connected to a ninth dissipative load (L62);

– two identical filters (61,62), the pass-band of which is centered on the frequency band (F"2), corresponding to the second transmission frequency, respectively connected to the first ($610_3$) and second ($610_4$) output ports of said first hybrid coupler (610);

– a second hybrid coupler (620), the input ports ($620_1$,$620_2$) of which are respectively connected to an output of each of the two identical filters (61,62) and the output ports ($620_3$,$620_4$) of which are themselves respectively connected to a tenth (L60) and an eleventh (L67) dissipative load.

9. A device according to one of the preceding claims, wherein said transmission channels (VE1,VE2), said reflective reception channel (VRR) and said transfer reception channel (VRT) comprise filtering means and means to amplify the filtered signal.

10. A device according to claim 9, wherein said filtering means (70,80,90,100) are constituted by a comb filter.

11. A device according to claim 1, wherein, for transmission frequencies (F1,F2) lower than about 1000 MHz, the interconnection (IC) of the various elements is achieved by means of coaxial cables.

12. A device according to one of claims 1 through 10, wherein, for transmission frequencies higher than 1200 MHz, the interconnection (IC) of the various elements is achieved in waveguide form.

13. A device according to claim 1, wherein the reflective reception channel (VRR) and the transfer reception channel (VRT) are connected to said measuring apparatus (AM) by means of a change-over switch (200).

14. The use of a measuring device according to claim 1 to measure intermodulation products of a receiver such as a radar receiver antenna or a satellite telecommunications antenna.

## FIG.1a

## FIG.1b

FIG.2